# EUROPEAN PATENT SPECIFICATION

(11) **EP 1 235 466 B1**
(45) Date of publication and mention of the grant of the patent: **03.10.2018**
(21) Application number: 01119918.9
(22) Date of filing: 17.08.2001
(51) Int. Cl.: H01L 51/30, C09K 11/06

(54) **Organic electroluminescent element and organic electroluminescent display**
Organisches lichtemittierendes Bauelement und organische elektrolumineszente Anzeigevorrichtung
Dispositif organique émetteur de lumière et affichage électroluminescent organique

(30) Priority: 19.02.2001 JP 2001042102
(43) Date of publication of application: 28.08.2002
(73) Proprietor: Samsung Display Co., Ltd., Gyeonggi-do (KR)
(72) Inventor: Motomatsu, Toshihiko, Minato-ku, Tokyo (JP); Sakaguchi, Yoshikazu, Minato-ku, Tokyo (JP)
(74) Representative: Gulde & Partner

(56) References cited:
- EP-A- 0 765 106
- EP-A- 1 033 904
- EP-A- 1 061 112
- PATENT ABSTRACTS OF JAPAN vol. 1999, no. 03, 31 March 1999 (1999-03-31) & JP 10 330295 A (MITSUI CHEM INC), 15 December 1998 (1998-12-15)

## Description

### BACKGROUND OF THE INVENTION

### (a) Field of the Invention

The present invention relates to an organic electroluminescent (EL) element, and more specifically to the red organic EL element having excellent luminescent efficiency, brightness and chromaticity, and an organic EL display using the organic EL element.

### (b) Description of the Related Art

In a conventional organic EL element, especially a conventional red organic EL element, an ordinarily used luminescent organic aluminum complex having a higher fluorescent quantum yield, or an aromatic amine derivative is used as a host, and the host doped with a red light emitting material is used as a luminescent layer for obtaining the brightness in a practical use.

The luminescent organic aluminum complex is designated by (Q)₃-Al (general formula [a], wherein "Q" is a substituted or non-substituted 8-quinolinolate ligand), and the aromatic amine derivative is designated by a general formula [b] (wherein each of A1 to A4 independently designates an aryl group having a carbon number between 6 and 18, and each of tR1 to R8 independently designates a hydrogen atom, a halogen atom, an alkyl group, an alkoxy group, an aryl group or an amino group).

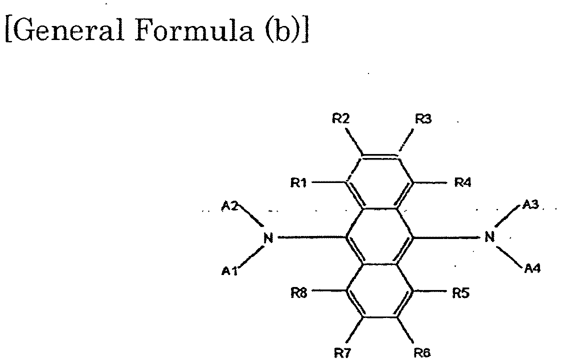

For example, in the organic EL element described in "An Overview of Organic Electroluminescent Materials and Devices", SID 96DIGEST, 14.1, pp.181-184 (1996) by C.W.Tang, a luminescent layer is prepared by doping a luminescent organic aluminum complex [tris-(8-quinolinolate) aluminum] designated by a compound [4] acting as a host, with a red luminescent material (DCJT). JP-A-10(1998)-72581 describes a luminescent layer formed by the aromatic amine derivative acting as a host, designated by the general formula [b], and doped with a red luminescent material.

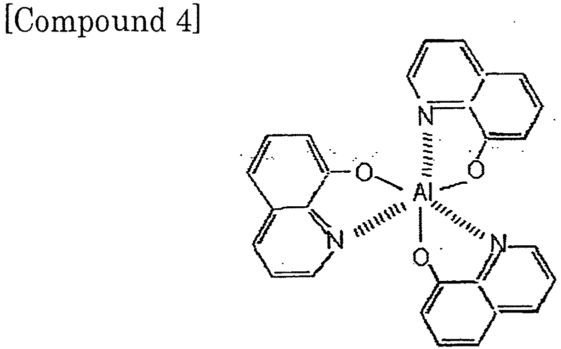

Further, EP 0 765 106 A2 discloses organic electroluminescent elements including a combination of aromatic amine derivatives with perylene as light-emitting material or doping material. JP 10330295 A describes perylene derivatives.

From the practical standpoint, the current organic EL element requires thermal stability. Accordingly, a hole injecting layer with the resistance to higher temperature is inserted between the anode and a hole transporting layer. Although the hole injecting layer extends a period of life of the organic EL element, the hole injecting ability into the luminescent layer is deteriorated. As a result, a recombination yield in the luminescent layer is lowered and a sufficient luminescent efficiency cannot be obtained. Further, a problem arises that an electron leaks from the luminescent layer due to an applied voltage, or a carrier balance is changed so that the hole transporting layer itself emits light to change the color shade.

A conventional organic EL element will be described with reference to the annexed drawing.

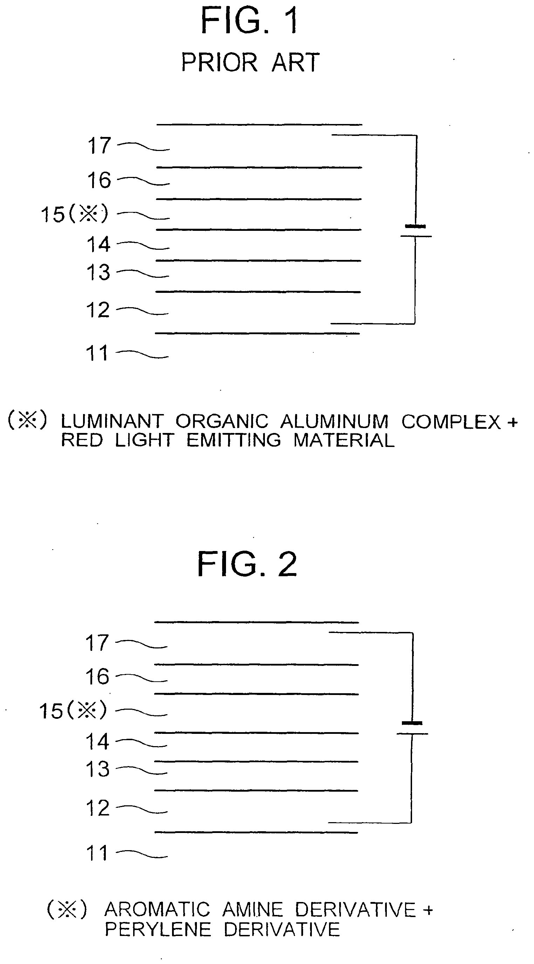

As shown in Fig.1, the conventional organic EL element includes a transparent anode 12 made of ITO (indium-tin oxide), a hole injecting layer 13, a hole transporting layer 14, a luminescent layer 15, an electron transporting layer 16 and a cathode 17 sequentially stacked on a glass substrate 11. The luminescent layer 15 includes, as a host, an organic metal complex having a higher fluorescent quantum yield (general formula [a]), doped with the red light emitting material. The same or another organic metal complex (general formula [a]) having the electron transporting ability may be used in the electron transporting layer 16.

As mentioned before, the use of the hole injecting layer with the resistance to higher temperature provides the reduction of the recombination yield between the hole and the electron in the luminescent layer, accompanied by the change of the color shade. Accordingly, the organic EL device having the excellent luminescent efficiency, the higher brightness and the permanently stabilized chromaticity cannot be conventionally obtained. This is because the hole injecting ability into the luminescent layer is low, and the electron transporting ability is changed due to increase of a voltage so that the recombination normally occurring in the luminescent layer actually occurs in the hole transporting layer in place of the luminescent layer.

### SUMMARY OF THE INVENTION

In view of the foregoing, an object of the present invention is to provide an organic EL element having the excellent luminescent efficiency, brightness and chromaticity.

The present invention provides an organic EL element including an anode and a cathode opposing to each other, and at least one luminescent layer, positioned therebetween, including an aromatic amine derivative designated by general formula [5] and a dibenzo-{[f,f']-4,4',7,7'-tetraphenyl}-diindeno[1,2,3-cd:1',2',3'-lm] perylene derivative designated by a general formula [2].

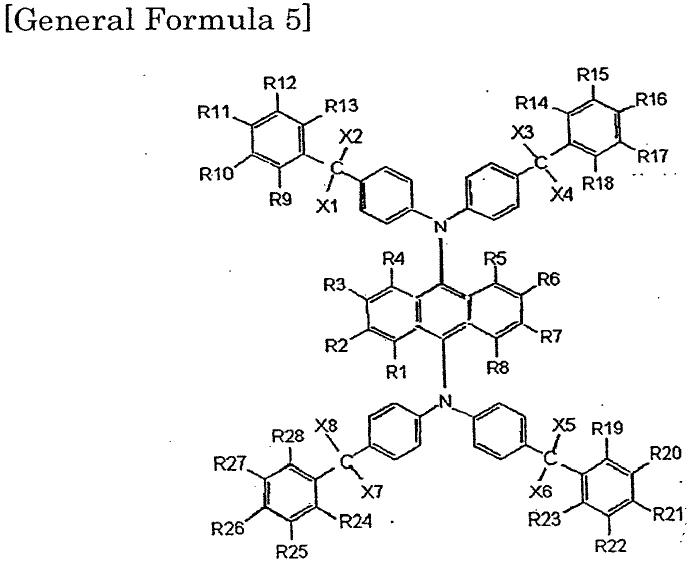

In Formula [5] each of R1 to R 28 is independently selected from the group consisting of a hydrogen atom, a halogen atom, a substituted or non-substituted alkyl group, a substituted or non-substituted alkoxy group, a substituted or non-substituted aryl group and a substituted or non-substituted amino group, each of X1 to X8 is independently selected from the group consisting of a substituted or non-substituted alkyl group having a carbon number of 1 to 20 and a substituted or non-substituted aryl group having a carbon number of 6 to 16, and two of R1 to R4 and/or two of R5 to R8 may be bonded to form a substituted or non-substituted five-membered or six-membered ring.

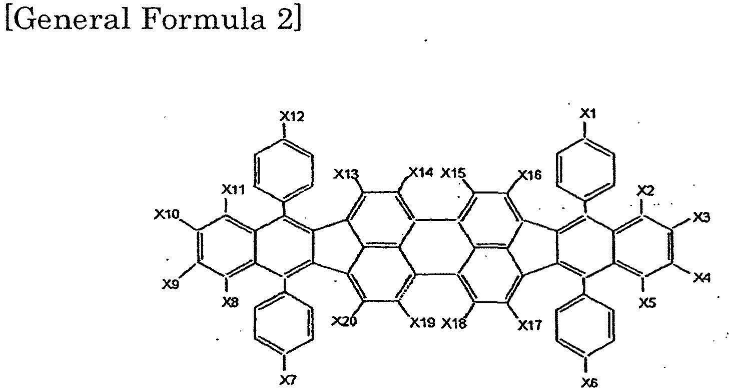

In Formula [2] each of X1 to X20 is independently selected from the group consisting of a hydrogen atom, a halogen atom, a substituted or non-substituted alkyl group, a substituted or non-substituted alkoxy group, a substituted or non-substituted aryl group and a substituted or non-substituted amino group, and two of X1 to X20 may be bonded to form a substituted or non-substituted five-membered or six-membered ring.

In accordance with the present invention, the aromatic amine derivative and the perylene derivative in the luminescent layer can provide an excellent hole transporting ability (electron blocking ability) to the luminescent layer. As a result, the hole injecting efficiency into the luminescent layer is improved to elevate the recombination efficiency between the hole and the electron in the luminescent layer, thereby providing the higher brightness. The luminescent layer also acts as an electron blocking layer to prevent the permeation of the electron through the luminescent layer, thereby elevating the purity of the color. Further, the combination of a triphenyldiamine derivatives designated by the general formula [5] has a longer period of life and the perylene derivative designated by the general formula [2] which is a non-crystalline material considerably extend the period of life.

Because of the excellent characteristics of the organic EL element, the organic EL display using the organic EL element also exhibits the excellent display characteristic.

When the electron injection layer or the electron transporting layer contains a plurality of the metal complexes designated by formula [3a] and/or [3b], the brightness can be maintained higher. If one organic metal complex is used in the electron injection layer or the electron transporting layer, the agglomeration or the crystallization of the film tends to proceed to deteriorate the electron injecting property and the electron transporting property. On the other hand, two organic metal complexes in the layer increase the amorphous property. Accordingly, the agglomeration or the crystallization hardly occurs even after a longer period of time to suppress the decrease of the electron injecting property and the electron transporting property.

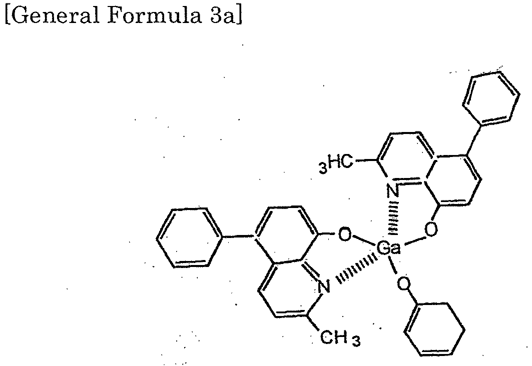

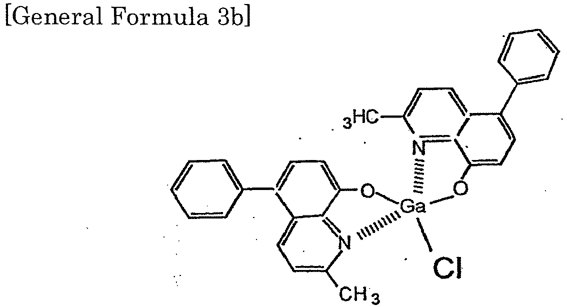

The above and other objects, features and advantages of the present invention will be more apparent from the following description.

### BRIEF DESCRIPTION OF DRAWINGS

Fig.1 is a schematic view of a conventional organic EL element.
Fig.2 is a schematic view of an organic EL element in accordance with an Embodiment of the present invention.
Fig.3 is a graph showing a relation between color shade and applied voltages of the organic EL element of the Embodiment compared with the relation of the conventional EL element.
Fig.4 is a graph showing a life characteristic of the organic EL element of the Embodiment.
Figs.5A and 5B are graphs showing an L-V characteristic and a J-V characteristic, respectively, of the device of Example 10 compared with a conventional device.

### PREFERRED EMBODIMENTS OF THE INVENTION

Now, the present invention is more specifically described with reference to accompanying drawings.

### Embodiment 1

As shown in Fig.2, an organic EL element of the present Embodiment includes a transparent anode 12 made of ITO (indium-tin oxide), a hole injecting layer 13, a hole transporting layer 14, a luminescent layer 15, an electron transporting layer 16 and a cathode 17 sequentially stacked on a glass substrate 11. The hole injecting layer 13 has an excellent resistance to higher temperature for improving the thermal stability of the organic EL element.

The luminescent layer 15 includes an aromatic amine derivative designated by a general formula [5] and a dibenzo-{[f,f']-4,4',7,7'-tetraphenyl}-diindeno[1,2,3-cd:1',2',3'-lm] perylene derivative designated by a general formula [2] mixed with each other. The doping amount of the perylene derivative is controlled by a vapor deposition rate, and is preferably between 1 and 10 % with respect to the aromatic amine derivative for suppressing the concentration quenching of pigment itself. The luminescent layer 15 may be formed by stacked two layers each containing the above perylene derivative having the different doping amounts.

The compound designated by the general formula [5] can be synthesized in accordance with a known process, for example, by reacting an anthracene derivative or an anthraquinone derivative with a substituted or non-substituted amine derivative under existence of potassium carbonate, sodium carbonate, potassium hydroxide or sodium hydroxide in a solvent such as benzene, toluene and xylene. A catalyst employable therefor includes copper powder, cuprous chloride, tin, stannous chloride and pyridine. The compound designated by the general formula [2] can be synthesized in accordance with a known process, for example, by reacting a benzo[k]fluoran derivative under existence of aluminum chloride/sodium chloride, cobalt fluoride or thallium trifluoroacetate.

The use of the organic metal complex designated by formula [3a] or formula [3b] having a higher ionization potential in the electron transporting layer 16 increases the ionization potential of the electron transporting layer larger than that of the luminescent layer. As a result, the hole blocking ability of the electron transporting layer 16 is improved for preventing the leakage of the hole into the electron transporting layer, thereby further elevating the recombination yield between the hole and the electron in the luminescent layer.

### Example 1

In an organic EL element of Example 1, an aromatic amine derivative designated by a compound [1] shown below was doped with dibenzotetraphenylperyfurantene designated by a compound [2] shown below in a vapor deposition rate of 2.5 % to prepare a luminescent layer. An electron transporting layer was prepared by using a gallium metal complex designated by a compound [3] shown below. As a result, red light emission could be obtained having a current efficiency of 6 cd/A or more (up to 1,000 cd/m²) and a maximum brightness of 38,000 cd/m² each of which was at the practical level. The chromaticity stability of the organic EL element was excellent, and the change of the color shade due to the applied voltage was small.

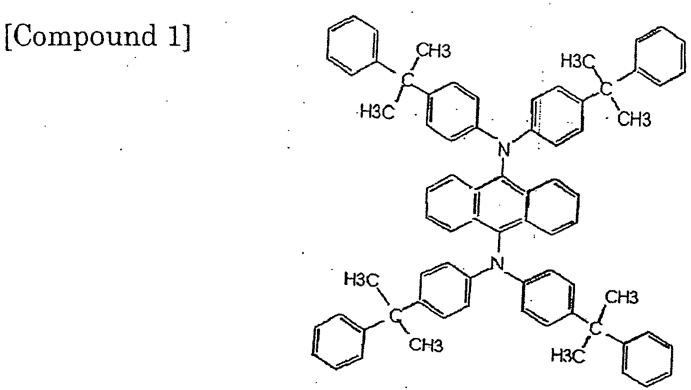

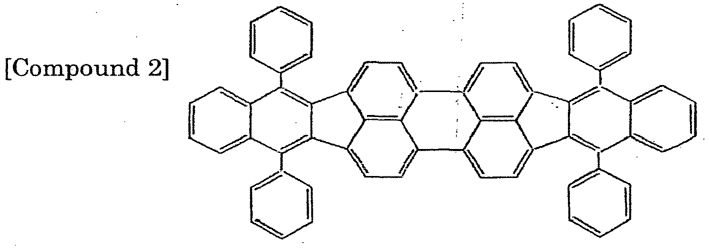

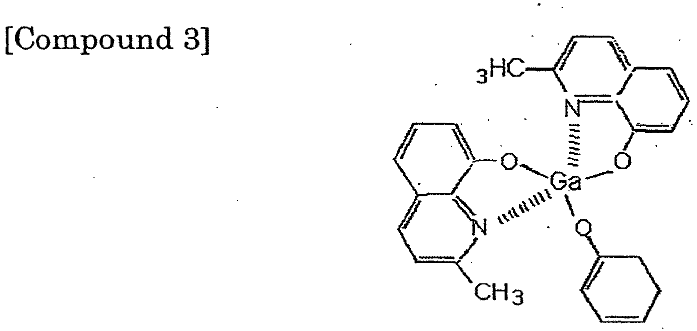

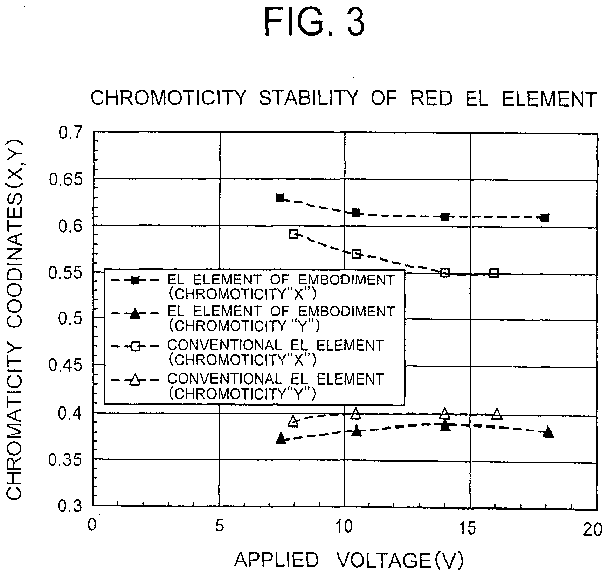

A graph of Fig.3 shows the relations between the applied voltage (V, abscissa) and the coordinates of "X" and "Y" of the CIE chromaticity (ordinate) of the organic EL element of the Example 1 and of the conventional organic EL element. As shown therein, the change of the color shade in the chromaticity "X" was suppressed when the applied voltage was increased, compared with the conventional EL element.

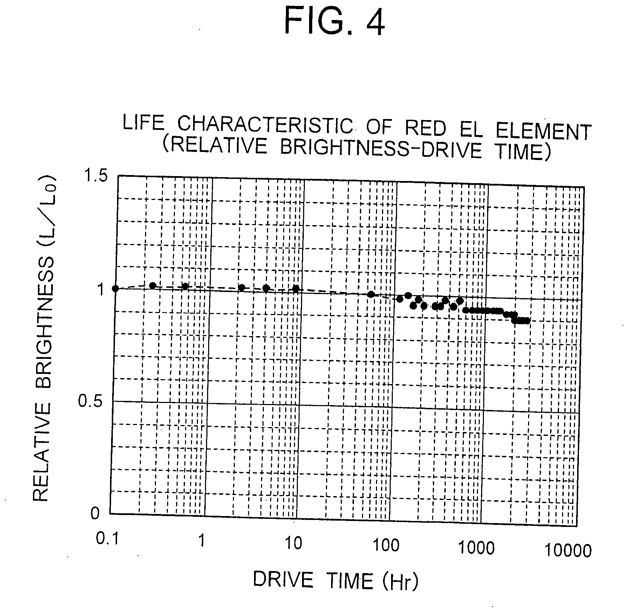

As shown in a graph of Fig.4 in which the abscissa indicates the driving time (Hr) and the ordinate indicates the relative brightness, the life characteristic of the organic EL element of the Example 1 at the constant current driving of 5 mA/cm² was improved. The organic EL element of the Example 1 maintained 90 % or more of the initial brightness even after the lapse of 3,000 hours. Further, dark spots (non-emitting section) were seldom observed.

### Comparative Example 1

Procedures similar to those used in the Example 1 were conducted except that the aromatic amine derivative of the compound [1] was added with the red light emitting material at 1 % in weight to prepare a luminescent layer (refer to JP-A-10(1998)-72581). Similar results to those of Example 1 were obtained; that is, the maximum emitting efficiency of 41 m/W and the maximum brightness of 38,000 cd/m². However, the life time of the organic EL element of Comparative Example 1 was short. The stable emission at 3 mA/cm² continued for only about 1000 hours, and the practical use thereof seemed difficult.

### Comparative Example 2

Procedures similar to the procedures used in Example 1 were conducted except that the compound [2] was used alone as luminescent layer (refer to JP-A-10(1998)-330295). Similar results to those of Example 1 were obtained, that is, red light emission having brightness of 1,250 cd/m² was obtained by applying a direct voltage of 15 V.

In addition, another luminescent layer was prepared by doping 4,4'-bis[N-phenyl-N- (1" - naphtyl)amino]biphenyl with the compound [2] at 5 % in weight. In the organic EL element using the luminescent layer, red light emission having brightness of 2,650 cd/m² was obtained by applying a direct voltage of 15 V.

However, the brightness of these organic EL elements was much lower than that of Example 1, and the practical use thereof seemed difficult.

### Comparative Example 3

Procedures similar to the procedures used in Example 1 were conducted except that the compound [4] was added with the compound [2] at 8 % in weight to prepare a luminescent layer (refer to JP-A-11(1999)-233261). Red light emission having brightness of about 52 cd/m² was obtained by applying a voltage of 9.7 V.

However, the brightness of the organic EL element after the stable and successive operation at the constant current for 2,700 hours was reduced as low as to 30 cd/m². The brightness of the organic EL element was much lower than that of Example 1 and the period of life was short. Accordingly, the practical use thereof seemed difficult.

### Comparative Example 4

Procedures similar to the procedures used in Example 1 were conducted except that the gallium metal complex designated by the compound [3] was used as an electron injecting layer (refer to JP-A-10(1998)-88121 in which the gallium metal complex [3] is used as a luminescent layer or an electron injecting layer). Bluish green light emission having brightness of 15,000 cd/m² and a luminescent efficiency of 2.351 m/W was obtained by applying a direct voltage of 8 V.

The brightness and the luminescent efficiency were insufficient, and the brightness, the luminescent efficiency, the period of life and the chromaticity stability could be improved by using the metal complex of the general formula [3] as the electron transporting layer of the red EL element.

### Comparative Example 5

Procedures similar to the procedures used in Example 1 were conducted except that a gallium metal complex [tris-(2-methyl-8-quinolinolate) gallium] and a perylene derivative were used as an electron injecting layer and a luminescent layer, respectively (refer to Japanese Patent No.2828821). Yellow light emission having brightness of 850 cd/m² was obtained by applying a direct voltage of 8 V. The period of life of light emission was 4 days. The brightness thereof was much lower than that of Example 1, and the period of life was quite short.

### Example 2 (not falling under the present invention)

Procedures similar to the procedures used in Example 1 were conducted except that the tris-(8-quinolinolate) aluminum designated by the general formula [4] was used as an electron transporting layer to fabricate an organic EL element. When a direct voltage was applied between a cathode and an anode of the EL element, red light emission could be obtained having a current efficiency of 6 cd/A or more (up to 1,000 cd/m²) and a maximum brightness of 38,000 cd/m².

### Example 3

Procedures similar to the procedures used in Example 1 were conducted except that the perylene derivative designated by the general formula [2b] was used, as a luminescent layer, in place of the aromatic amine derivative designated by the compound [1]. When a direct voltage was applied between a cathode and an anode of the EL element, red light emission could be obtained having a current efficiency of 5 cd/A or more (up to 1,000 cd/m²) and a maximum brightness of 33,000 cd/m².

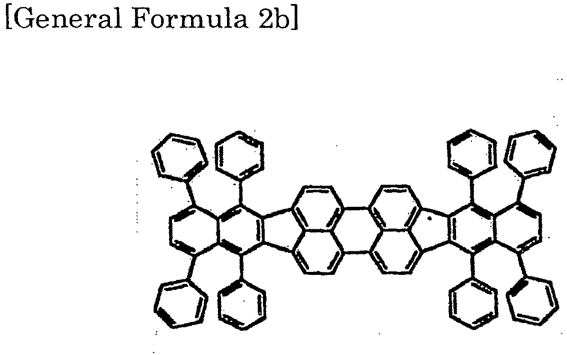

### Example 4

The aromatic amine derivative designated by the compound I was doped with the compound [2b] at a vaporization rate of 2.5 % to fabricate the luminescent layer of the organic EL device of the present Example. The gallium metal complex [3a] was used to prepare the electron transporting layer. When a direct voltage was applied between a cathode and an anode of the EL element, red light emission could be obtained having a current efficiency of 6.8 cd/A or more (up to 1,000 cd/m²) and a maximum brightness of 45,000 cd/m².

### Example 5

The organic EL device was fabricated in accordance with the procedures of Example 4 except that the gallium metal complexes [3a] and [3b] were used to prepare the electron transporting layer. The ratio between the gallium metal complexes [3a] and [3b] was 9:1 in weight. When a direct voltage was applied between a cathode and an anode of the EL element, red light emission could be obtained having a current efficiency of 6.6 cd/A or more (up to 1,000 cd/m²) and a maximum brightness of 43,000 cd/m².

### Example 6

The organic EL device was fabricated in accordance with the procedures of Example 4 except that the gallium metal complex [3] was used to prepare the electron transporting layer. When a direct voltage was applied between a cathode and an anode of the EL element, red light emission could be obtained having a current efficiency of 6 cd/A or more (up to 1,000 cd/m²) and a maximum brightness of 38,000 cd/m².

### Example 7

The aromatic amine derivative designated by the compound I was doped with a compound of general formula [2a] at a vaporization rate of 2.5 % to fabricate the luminescent layer of the organic EL device of the present Example. The gallium metal complex [3a] was used to prepare the electron transporting layer. When a direct voltage was applied between a cathode and an anode of the EL element, red light emission could be obtained having a current efficiency of 6.5 cd/A or more (up to 1,000 cd/m²) and a maximum brightness of 42,000 cd/m².

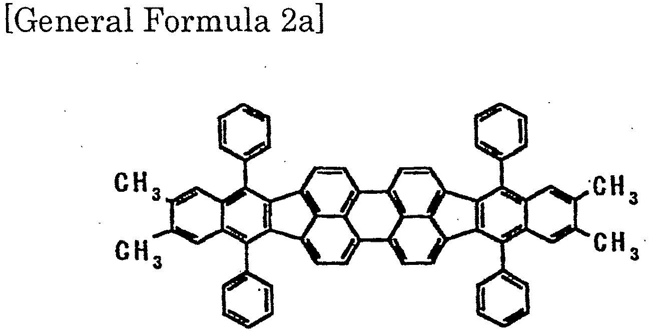

### Example 8

The organic EL device was fabricated in accordance with the procedures of Example 7 except that the gallium metal complexes [3a] and [3b] were used to prepare the electron transporting layer. The ratio between the gallium metal complexes [3a] and [3b] was 9:1 in weight. When a direct voltage was applied between a cathode and an anode of the EL element, red light emission could be obtained having a current efficiency of 6.4 cd/A or more (up to 1,000 cd/m²) and a maximum brightness of 41,000 cd/m².

### Example 9

The organic EL device was fabricated in accordance with the procedures of Example 7 except that the gallium metal complex [3] was used to prepare the electron transporting layer. When a direct voltage was applied between a cathode and an anode of the EL element, red light emission could be obtained having a current efficiency of 5.8 cd/A or more (up to 1,000 cd/m²) and a maximum brightness of 37,000 cd/m².

The characteristics of the organic EL devices of Examples 1 and 4 to 8 are shown in Table 1.

**Table 1**

| | Life Time at Efficiency | | at Maximum | Life Time at Chromaticity | |
|---|---|---|---|---|---|
| | Room (hr)* | Temp. 100cd/m² (cd/A) | Brightness (cd/m²) | 85 °C (hr)* | @1000 cd/m² |
| Example 1 | 10000 | 6 | 38000 | 500 | (0.62,0.38) |
| Example 4 | 15000 | 6.8 | 45000 | 1900 | (0.63,0.36) |
| Example 5 | 16000 | 6.6 | 43000 | ≧ 2000 | (0.63,0.37) |
| Example 6 | 10000 | 6 | 38000 | 700 | (0.63,0.37) |
| Example 7 | ≧ 12000 | 6.5 | 42000 | 1600 | (0.62,0.37) |
| Example 8 | ≧ 12000 | 6.4 | 41000 | ≧ 2000 | (0.62,0.37) |
| Example 9 | 10000 | 5.8 | 37000 | 600 | (0.62,0.38) |

| | | | | | |
|---|---|---|---|---|---|
| * Initial: 200 cd/m² | | | | | |

### Example 10

The aromatic amine derivative designated by the compound I was doped with dibenzotetraphenylperifurantene of the compound [2] at a vaporization rate of 2.5 % to fabricate the luminescent layer. The gallium metal complex [3a] was used to prepare the electron transporting layer in the present Example.

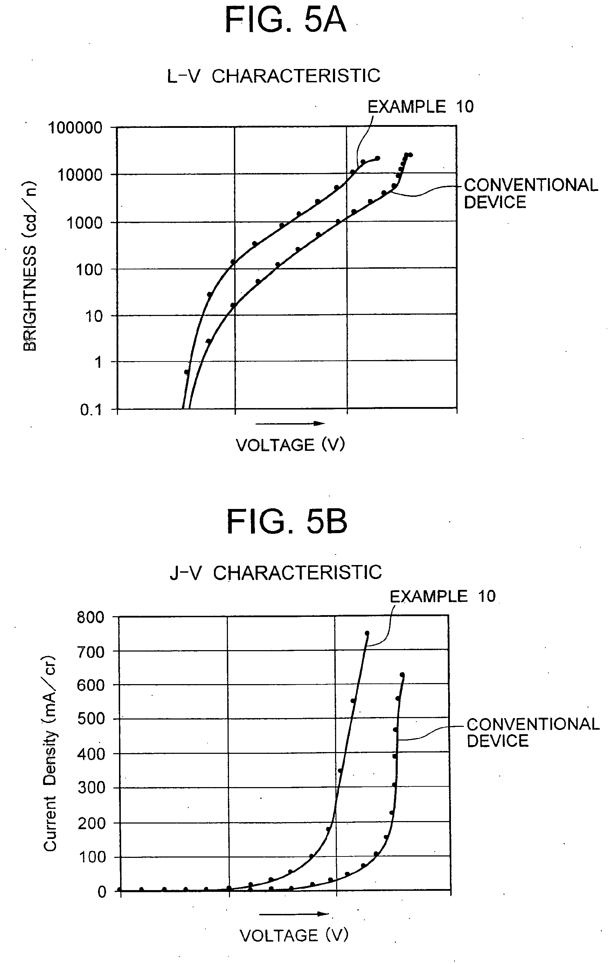

The L-V characteristic and the J-V characteristic of the device of Example 10 compared with a conventional device were shown in Figs.5A and 5B, respectively. The conventional device included the luminescent layer having tris-(8-quinolinolate) aluminum designated by the compound [4] doped with the red dopant (DCM) designated by the compound [5], and the electron transporting layer having tris-(8-quinolinolate) aluminum designated by the compound [4]. As apparently shown in the graphs of Figs.5A and 5B, the device of Example 10 could be operated at the lower voltage than the conventional red device.

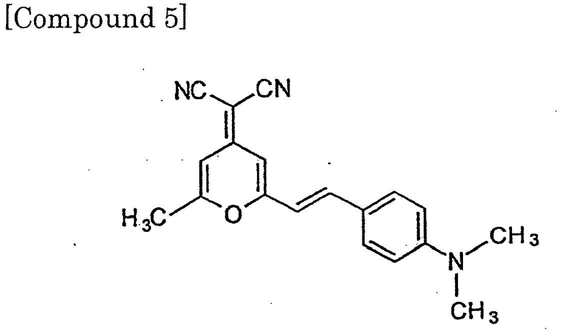

## Claims

1. An organic EL element comprising an anode and a cathode opposing to each other, and at least a luminescent layer, positioned therebetween, including an aromatic amine derivative designated by a general formula [5] 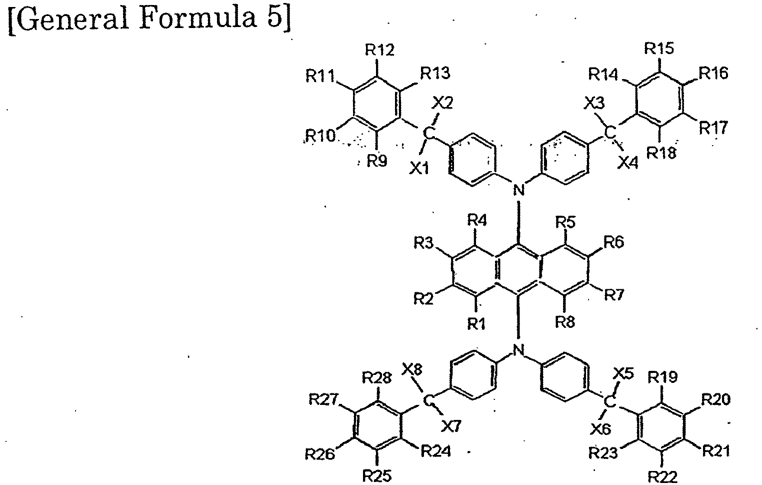 wherein each of R1 to R 28 is independently selected from the group consisting of a hydrogen atom, a halogen atom, a substituted or non-substituted alkyl group, a substituted or non-substituted alkoxy group, a substituted or non-substituted aryl group and a substituted or non-substituted amino group, each of X1 to X8 is independently selected from the group consisting of a substituted or non-substituted alkyl group having a carbon number of 1 to 20 and a substituted or non-substituted aryl group having a carbon number of 6 to 16, and two of R1 to R4 and/or two of R5 to R8 may be bonded to form a substituted or non-substituted five-membered or six-membered ring and
a dibenzo{[f,f']-4,4',7,7'-tetraphenyl}-diindeno[1,2,3-cd:1',2',3'-lm] perylene derivative designated by a general formula [2] 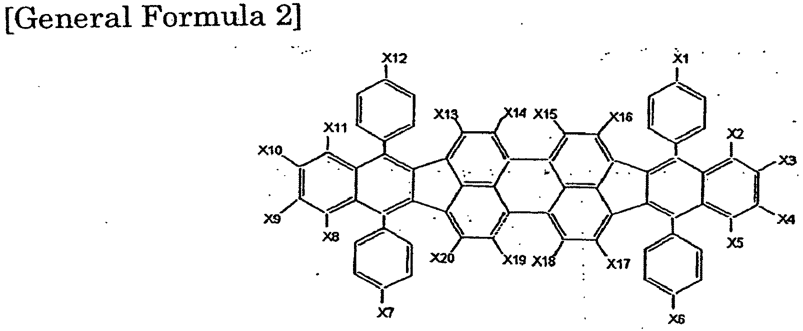 wherein each of X1 to X20 is independently selected from the group consisting of a hydrogen atom, a halogen atom, a substituted or non-substituted alkyl group, a substituted or non-substituted alkoxy group, a substituted or non-substituted aryl group and a substituted or non-substituted amino group, and two of X1 to X20 may be bonded to form a substituted or non-substituted five-membered or six-membered ring.

2. The organic EL element as defined in claim 1, wherein the aromatic amine derivative designated by the general formula [5] is used as a host doped with the perylene derivative designated by the general formula [2] at a doping ratio between 1 and 10 %.

3. The organic EL element as defined in claim 1 further comprising an electron injection layer or an electron transporting layer including an organic metal complex, wherein the organic metal complex is a compound designated by formula [3a]

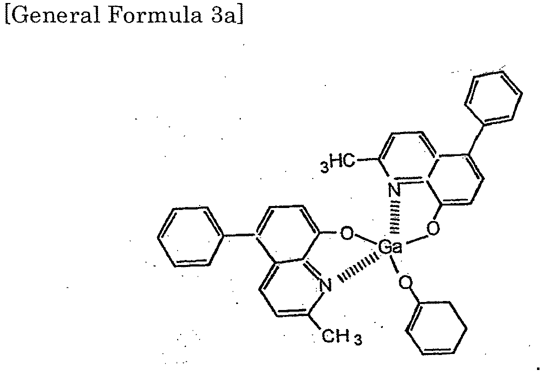

4. The organic EL element as defined in claim 1 further comprising an electron injection layer or an electron transporting layer including an organic metal complex, wherein the organic metal complex is a compound designated by formula [3b]

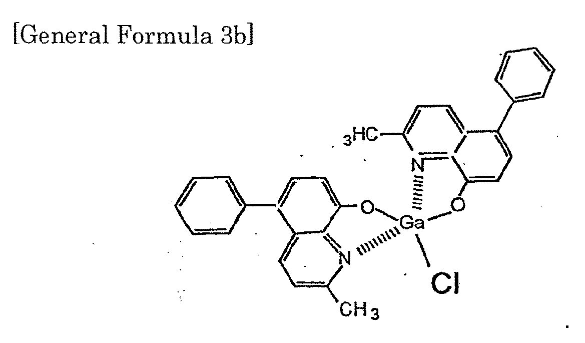

5. The organic EL element as defined in claim 3 and claim 4, wherein the electron injection layer or the electron transporting layer includes the compounds designated by the general formulae [3a] and [3b].

6. The organic EL element as defined in claim 3 or claim 4, wherein the electron injection layer or the electron transporting layer includes a luminescent organic aluminum complex designated by (Q)₃-Al wherein "Q" is a substituted or non-substituted 8-quinolinolate ligand.

7. An organic EL display comprising the organic EL element as defined in claim 1.

## Patentansprüche

1. Organisches EL-Bauelement, umfassend eine Anode und eine Kathode, einander gegenüberliegend, und mindestens eine Lumineszenzschicht, dazwischen positioniert, umfassend ein aromatisches Aminderivat, angegeben durch eine allgemeine Formel [5], 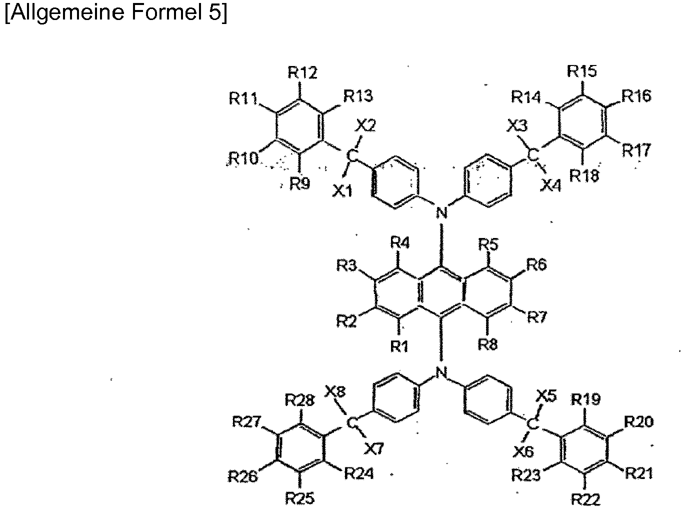 wobei jedes von R1 bis R28 unabhängig voneinander ausgewählt ist aus der Gruppe bestehend aus einem Wasserstoffatom, einem Halogenatom, einem substituierten oder unsubstituierten Alkylrest, einem substituierten oder unsubstituierten Alkoxyrest, einem substituierten oder unsubstituierten Arylrest und einer substituierten oder unsubstituierten Aminogruppe, jedes von X1 bis X8 unabhängig voneinander ausgewählt ist aus der Gruppe bestehend aus einem substituierten oder unsubstituierten Alkylrest mit einer Kohlenstoffanzahl von 1 bis 20 und einem substituierten oder unsubstituierten Arylrest mit einer Kohlenstoffanzahl von 6 bis 16, und zwei von R1 bis R4 und/oder zwei von R5 bis R8 verbunden sein können, um einen substituierten oder unsubstituierten fünfgliedrigen oder sechsgliedrigen Ring zu bilden, und
ein Dibenzo{[f,f']-4,4',7,7'-tetraphenyl}diindeno[1,2,3-cd:1',2',3'-lm]perylen-Derivat, angegeben durch eine allgemeine Formel [2], 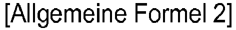 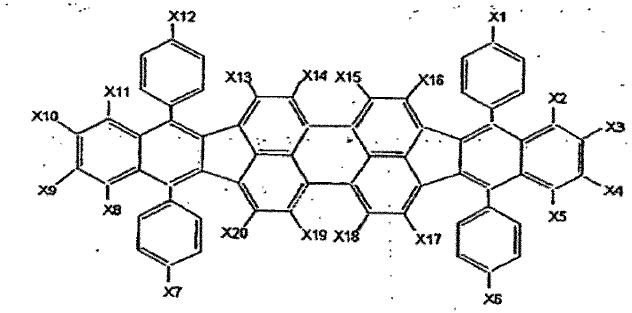 wobei jedes von X1 bis X20 unabhängig voneinander ausgewählt ist aus der Gruppe bestehend aus einem Wasserstoffatom, einem Halogenatom, einem substituierten oder unsubstituierten Alkylrest, einem substituierten oder unsubstituierten Alkoxyrest, einem substituierten oder unsubstituierten Arylrest und einer substituierten oder unsubstituierten Aminogruppe, und zwei von X1 bis X20 verbunden sein können, um einen substituierten oder unsubstituierten fünfgliedrigen oder sechsgliedrigen Ring zu bilden.

2. Organisches EL-Bauelement nach Anspruch 1, wobei das durch die allgemeine Formel [5] angegebene aromatische Aminderivat als Hostmaterial, dotiert mit dem durch die allgemeine Formel [2] angegebenen Perylen-Derivat mit einem Dotierungsanteil zwischen 1 und 10 %, verwendet wird.

3. Organisches EL-Bauelement nach Anspruch 1, weiterhin umfassend eine Elektroneninjektionsschicht oder eine Elektronentransportschicht, umfassend einen organischen Metallkomplex, wobei der organische Metallkomplex eine durch Formel [3a] angegebene Verbindung ist

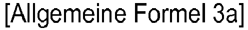

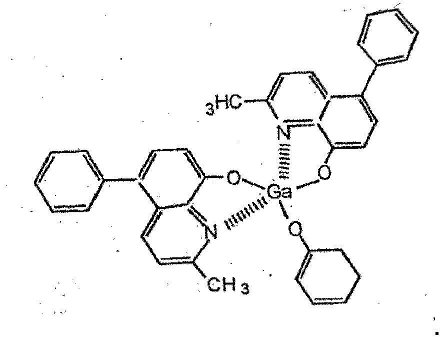

4. Organisches EL-Bauelement nach Anspruch 1, weiterhin umfassend eine Elektroneninjektionsschicht oder eine Elektronentransportschicht, umfassend einen organischen Metallkomplex, wobei der organische Metallkomplex eine durch Formel [3b] angegebene Verbindung ist

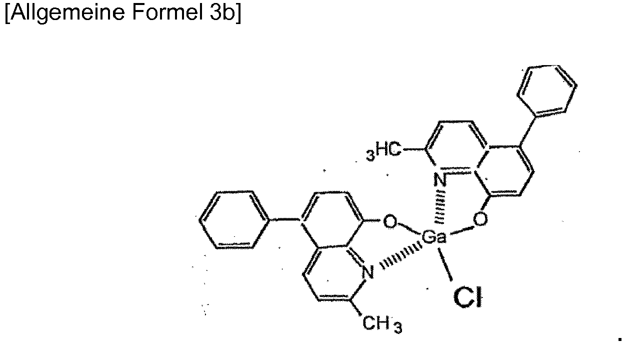

5. Organisches EL-Bauelement nach Anspruch 3 und Anspruch 4, wobei die Elektroneninjektionsschicht oder die Elektronentransportschicht die durch die allgemeinen Formeln [3a] und [3b] angegebenen Verbindungen umfasst.

6. Organisches EL-Bauelement nach Anspruch 3 oder Anspruch 4, wobei die Elektroneninjektionsschicht oder die Elektronentransportschicht einen lumineszierenden organischen Aluminiumkomplex, angegeben durch (Q)₃-Al, umfasst, wobei "Q" ein substituierter oder unsubstituierter 8-Chinolinolat-Ligand ist.

7. Organische EL-Anzeige, umfassend das organische EL-Bauelement nach Anspruch 1.

## Revendications

1. Élément électroluminescent (EL) organique comprenant une anode et une cathode opposées l'une à l'autre, et au moins une couche luminescente, positionnée entre celles-ci, comprenant un dérivé d'amine aromatique représenté par une formule générale [5] : 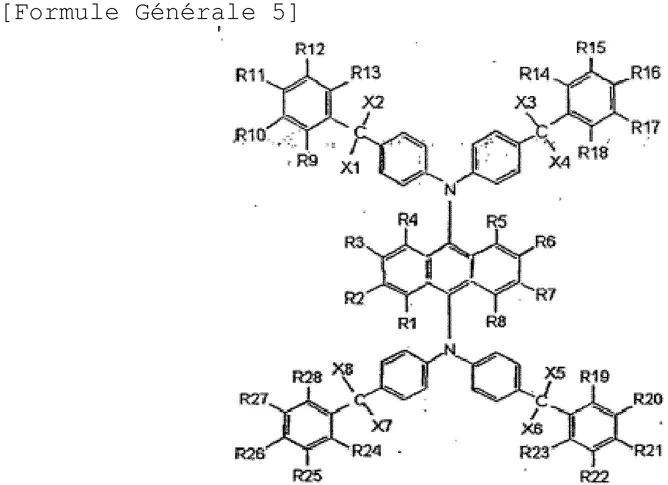 dans laquelle chacun de R1 à R28 est indépendamment sélectionné parmi le groupe constitué par un atome d'hydrogène, un atome d'halogène, un groupe alkyle substitué ou non substitué, un groupe alkoxy substitué ou non substitué, un groupe aryle substitué ou non substitué et un groupe amino substitué ou non substitué, chacun de X1 à X8 est indépendamment sélectionné parmi le groupe constitué par un groupe alkyle substitué ou non substitué ayant un nombre de carbones compris entre 1 et 20 et un groupe aryle substitué ou non substitué ayant un nombre de carbones compris entre 6 et 16, et deux parmi R1 à R4 et/ou deux parmi R5 à R8 peuvent être liés pour former un cycle à cinq chaînons ou à six chaînons substitué ou non substitué, et
un dérivé de dibenzo{[f,f']-4,4',7,7'-tétraphényl}-diindéno[1,2,3-cd:1',2',3'-lm]pérylène représenté par une formule générale [2] : 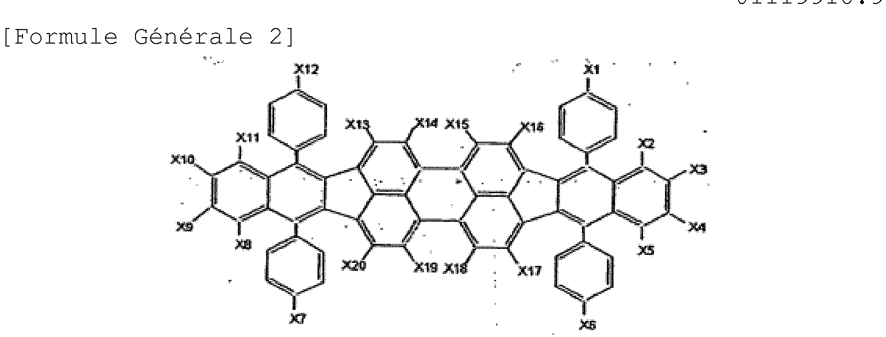 dans laquelle chacun de X1 à X20 est indépendamment sélectionné parmi le groupe constitué par un atome d'hydrogène, un atome d'halogène, un groupe alkyle substitué ou non substitué, un groupe alkoxy substitué ou non substitué, un groupe aryle substitué ou non substitué et un groupe amino substitué ou non substitué, et deux parmi X1 à X20 peuvent être liés pour former un cycle à cinq chaînons ou à six chaînons substitué ou non substitué.

2. Élément EL organique selon la revendication 1, dans lequel le dérivé d'amine aromatique représenté par la formule générale [5] est utilisé comme hôte dopé avec le dérivé de pérylène représenté par la formule générale [2] à un taux de dopage compris entre 1 et 10 %.

3. Élément EL organique selon la revendication 1, comprenant en outre une couche d'injection d'électrons ou une couche de transport d'électrons comprenant un complexe organométallique, le complexe organométallique étant un composé représenté par la formule [3a] :

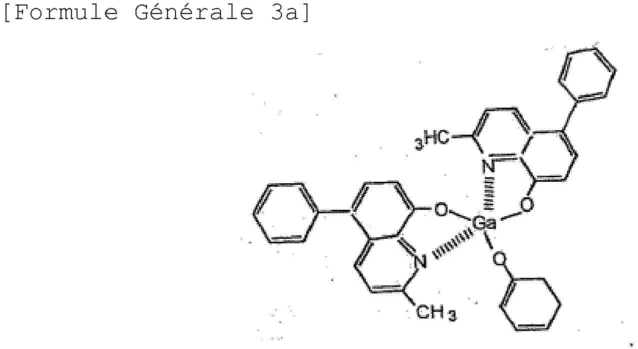

4. Élément EL organique selon la revendication 1, comprenant en outre une couche d'injection d'électrons ou une couche de transport d'électrons comprenant un complexe organométallique, le complexe organométallique étant un composé représenté par la formule [3b] :

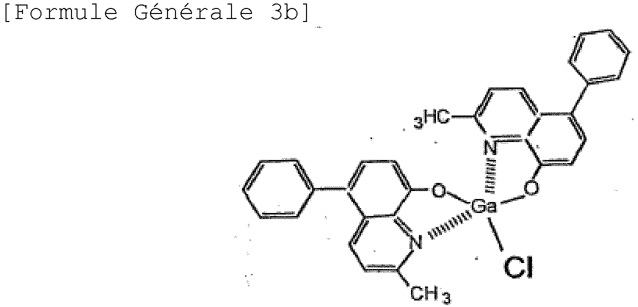

5. Élément EL organique selon la revendication 3 et la revendication 4, dans lequel la couche d'injection d'électrons ou la couche de transport d'électrons comprend les composés représentés par les formules générales [3a] et [3b].

6. Élément EL organique selon la revendication 3 ou la revendication 4, dans lequel la couche d'injection d'électrons ou la couche de transport d'électrons comprend un complexe d'aluminium organique luminescent représenté par (Q)₃-Al dans lequel « Q » est un ligand 8-quinolinolate substitué ou non substitué.

7. Dispositif d'affichage EL organique comprenant l'élément EL organique défini selon la revendication 1.
